(19) Europäisches Patentamt
European Patent Office
Office européen des brevets

(11) **EP 1 970 467 B1**

(12) **EUROPÄISCHE PATENTSCHRIFT**

(45) Veröffentlichungstag und Bekanntmachung des Hinweises auf die Patenterteilung:
**16.05.2012 Patentblatt 2012/20**

(51) Int Cl.:
*C23C 14/56* *(2006.01)*    *B65G 49/06* *(2006.01)*

(21) Anmeldenummer: **07104144.6**

(22) Anmeldetag: **14.03.2007**

(54) **Flutungskammer für Beschichtungsanlagen**

Flood chamber for coating installations

Chambre de refoulement pour installations de revêtement

(84) Benannte Vertragsstaaten:
**AT BE BG CH CY CZ DE DK EE ES FI FR GB GR HU IE IS IT LI LT LU LV MC MT NL PL PT RO SE SI SK TR**

(43) Veröffentlichungstag der Anmeldung:
**17.09.2008 Patentblatt 2008/38**

(73) Patentinhaber: **Applied Materials, Inc.**
**Santa Clara, CA 95054 (US)**

(72) Erfinder:
• **Gebele, Thomas**
**63579 Freigericht (DE)**
• **Lopp, Andreas**
**63579 Freigericht (DE)**
• **Heimel, Oliver**
**34590 Wabern (DE)**

(74) Vertreter: **Schickedanz, Willi**
**Langener Strasse 68**
**63073 Offenbach (DE)**

(56) Entgegenhaltungen:
**EP-A2- 1 172 842     WO-A-2004/096678**
**DE-A1- 10 119 766     US-A- 6 016 611**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine Flutungskammer nach dem Oberbegriff des Patentanspruchs 1.

Bei Hochvakuumbeschichtungsanlagen werden oft Ein- und Ausschleuskammern vorgesehen, die vor bzw. hinter der eigentlichen Hochvakuumbeschichtungskammer angeordnet sind. Durch diese Ein- und Ausschleuskammern werden die zu beschichtenden Substrate, beispielsweise Glasscheiben geführt, um nicht bei jedem einzelnen Substrat die gesamte Hochvakuumsbeschichtungskammer erneut evakuieren zu müssen. Während die Einschleuskammer die Funktion hat, das Substrat vom Atmosphärendruckbereich in den Vakuumbereich zu überführen, hat die Ausschleuskammer die Aufgabe, das nunmehr beschichtete Substrat vom Vakuum in den Atmosphärendruckbereich zu überführen.

Eine Beschichtungsanlage mit einer Einschleuskammer, einer Prozesskammer und einer Ausschleuskammer ist beispielsweise aus Fig. 1 der DE 10 2004 008 598 A1 bekannt. Zwischen der Ein- und Ausschleuskammer einerseits und der Prozesskammer andererseits können auch noch Pufferkammern vorgesehen sein. Eine solche Beschichtungsanlage wird auch Inline-Anlage genannt.

In der Einlasskammer wird der Druck auf einen geeigneten Übergangsdruck gebracht, z. B. auf $p = 5 \cdot 10^{-3}$ hPa. In der nachfolgenden Prozesskammer herrscht dann ein Druck von z. B. $p = 1 \cdot 10^{-3}$ hPa, während der Druck in der hierauf folgenden Ausschleuskammer vom Prozesskammerdruck auf Atmosphärendruck gebracht wird.

Die Zeit, die notwendig ist, um die Einschleuskammer auf den erforderlichen Übergangsdruck zu bringen, bestimmt bei vorgegebenen Substrattransport- und Ventil-Schaltzeiten maßgeblich die Zykluszeit.

In neuen Anlagen, in denen immer häufiger sehr dünne Glasscheiben oder sonstige flächige Substrate beschichtet werden, ist indessen die Zeit, in der die Ausschleuskammer auf den erforderlichen Druck gebracht wird, immer wichtiger geworden. Da bei schnellem Fluten die Substrate leicht zerstört bzw. beschädigt werden, lassen sich nur Flutzeiten im Bereich von 8 s bis 12 s erreichen.

Mitentscheidend für die Produktivität einer Inline-Beschichtungsanlage ist die Zyklus- oder Taktzeit, d. h. die Zeit, die pro Substratbeschichtung aufgewendet werden muss. Um eine Zykluszeit von 45 Sekunden zu erreichen, muss das Schleusensystem in der Lage sein, ein Substrat in weniger als 45 Sekunden von einem Punkt in Atmosphäre zu einem Punkt im Hochvakuumbereich zu bringen und umgekehrt. Innerhalb dieser Zeit muss das Substrat in und aus den Schleusen transportiert werden, die Schleusen evakuiert bzw. belüftet werden. Die zum Evakuieren und Fluten zur Verfügung stehende Zeit ist dann in der Regel kleiner als die Zykluszeit, beispielsweise 20 Sekunden von 45 Sekunden, da auch alle anderen Aufgaben innerhalb der Zykluszeit erledigt werden müssen.

Aus der bekannten Gleichung

$$t = \frac{V}{S} \cdot \ln\left(\frac{p_0}{p_1}\right)$$

mit

t = Pumpzeit

V = Volumen

S = Saugvermögen

$p_0$ = Startdruck (Atmosphärendruck)

$p_1$ = Zieldruck (Übergabedruck, Umschleusdruck)

ergibt sich, dass die Pumpzeit und damit auch die Zykluszeit durch folgende Maßnahmen verkleinert werden können:

- Reduzierung des Volumens der Schleusenkammern

- Vergrößern des Saugvermögens

- Verkleinern des Verhältnisses von $p_0$ zu $p_1$

In der Praxis wird in der Regel das Reduzieren des Volumens der Schleusenkammern bevorzugt. Leider ist mit der Volumenreduzierung häufig der negative Effekt verbunden, dass beim schnellen Fluten größere Druckdifferenzen in den Schleusen entstehen, welche die Substrate zerstören oder aus ihrer Position bringen.

Es ist indessen bereits eine Vorrichtung zum Transportieren eines flachen Substrats in einer Vakuumkammer bekannt, bei der gegenüber einer Seite des flachen Substrats ein Gaskanal mit Bohrungen in Richtung auf das flache Substrat vorgesehen ist (WO 2004/096678 A1). Das hierbei vorhandene Gaspolster verhindert, dass das Substrat auf einer Auflage liegt und dort beschädigt wird.

Weiterhin ist eine kaskadenförmige Gaszuführung für eine Vakuumkammer bekannt, bei der mehrere Öffnungen in einer Wand aus der gleichen Gasquelle gespeist werden (DE 101 19 766 A1).

Es ist indessen bereits eine Beschichtungsanlage bekannt, bei der ein Substrat auf beiden Seiten von einem Plasma umgeben ist (US 2005/0103271 A1). Dieses Plasma übt jedoch keine Haltefunktion bezüglich des Substrats aus.

Mit einer Verkürzung der Zykluszeit haben die bekannten Vorrichtungen nichts zu tun.

Der Erfindung liegt die Aufgabe zugrunde, die Zykluszeit durch eine kürzere Flutzeit herabzusetzen.

Diese Aufgabe wird gemäß den Merkmalen des Patentanspruchs 1 gelöst.

Die Erfindung betrifft somit eine Flutungskammer für Beschichtungsanlagen, mit welcher kürzere Flutungszeiten und damit kürzere Taktzeiten erreicht werden können. Dabei kommen zwei Flutungseinrichtungen zum Einsatz, zwischen denen ein Substrat symmetrisch angeordnet ist. Die Flutungseinrichtungen richten einen Gasstrahl direkt auf das Substrat. Hierdurch wird das Substrat zwischen den Flutungseinrichtungen fixiert.

Der mit der Erfindung erzielte Vorteil besteht insbesondere darin, dass durch die Schnellflutung mittels einer hohen Gasströmung das Substrat nicht vom Transportsystem herunter und an die Schleusenkammerwände geblasen wird. Dadurch, dass das Substrat von Strömungskräften beaufschlagt wird, die sich am Substrat selbst aufheben, gibt es keine Kraft, die das Substrat umwerfen könnte.

Durch die Verkürzung der Flutzeit von z. B. 10 Sekunden auf nur noch 2 Sekunden kann die Zykluszeit um z. B. 8 Sekunden reduziert werden. Ein weiterer Vorteil der Erfindung besteht darin, dass das Substrat während des Flutens zwischen den Fluteinrichtungen fixiert wird, d. h. die Fluteinrichtungen selbst wirken als berührungslose Halter für das Substrat. Gleichzeitig entsteht eine dämpfende Kopplung zwischen Substrat und Fluteinrichtung, die möglichen Schwingungen des Substrats entgegenwirkt.

Im Gegensatz zu dem bekannten Luftkissentransport von flachen Substraten wird bei der vorliegenden Erfindung das Substrat an mehreren Stellen lokal durch einen hohen dynamischen Druck - realisiert durch Gasstrahlen - festgehalten, d. h. in der Mitte fixiert. Dabei wird der statische Druck, der durch in das Kammervolumen strömendes Gas entsteht, an einem Verschieben des Substrats aus der Transportebene gehindert.

Ausführungsbeispiele der Erfindung sind in den Zeichnungen dargestellt und werden im Folgenden näher beschrieben. Es zeigen:

Fig. 1 eine Prinzipdarstellung einer Inline-Beschichtungsanlage mit einer Einschleuskammer, einer Prozesskammer und einer Ausschleuskammer;

Fig. 2 eine Ansicht auf die Schmalseite der Ausschleuskammer;

Fig. 3 eine Ansicht auf eine Ausschleuskammer mit zwei Gaszuführungen;

Fig. 4 eine Ansicht auf eine Ausschleuskammer mit mittiger Gaszuführung;

Fig. 5 eine Darstellung der auf ein Substrat einwirkenden Kräfte;

Fig. 6 eine Darstellung der Kräfte, die auf ein gekipptes Substrat einwirken;

Fig. 7a eine perspektivische Ansicht einer weiteren Ausführungsform einer Ausschleuskammer;

Fig. 7b eine Frontansicht der in der Fig. 7a gezeigten Ausschleuskammer.

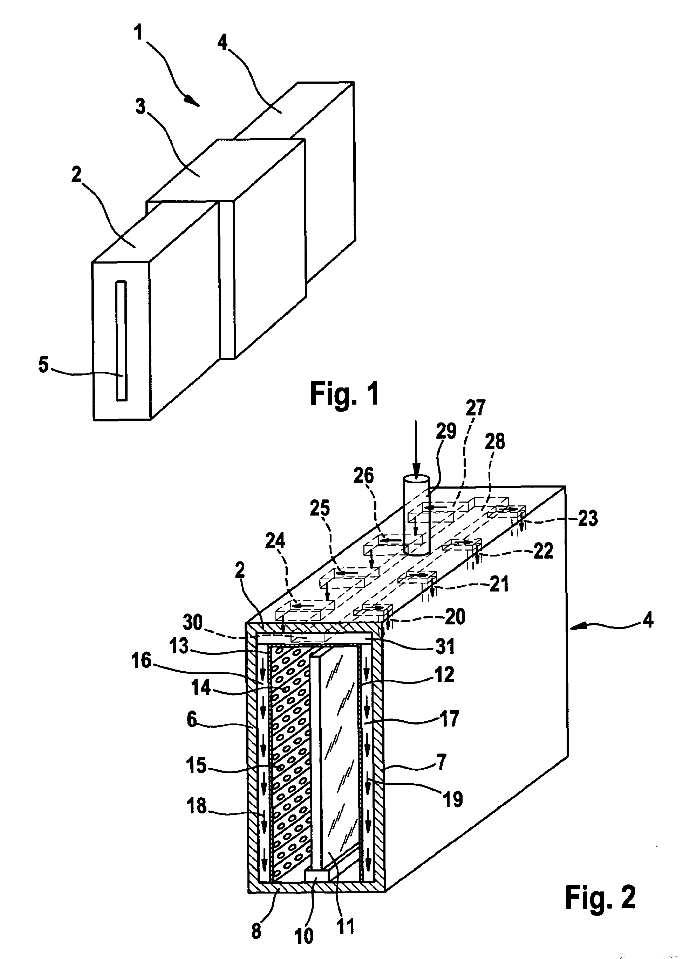

In der Fig. 1 ist eine Prinzipdarstellung einer Inline-Beschichtungsanlage 1 mit einer Einschleuskammer 2, einer Prozesskammer 3 und einer Ausschleuskammer 4 gezeigt. Ein zu beschichtendes flächiges Substrat, beispielsweise eine Glasscheibe, wird durch eine Öffnung 5 der Einschleuskammer 2 eingeführt und zur Prozesskammer 3 transportiert, wo das Substrat beschichtet wird. Nach der Beschichtung gelangt das Substrat in die Ausschleuskammer 4 und von dort nach draußen.

Die Fig. 2 zeigt die Ausschleuskammer 4 noch einmal in Alleinstellung. Man erkennt hierbei vier Schleusenkammerwände 6 bis 9 sowie eine Transportvorrichtung 10 für ein Substrat 11, das hier eine Glasscheibe ist. Mit 12 und 13 sind Flutwände bezeichnet, die mit mehreren Löchern 14, 15 versehen sind. Die Flutwände 12, 13 bilden zusammen mit den Innenseiten der Schleusenkammerwände 6, 7 einen Flutkanal 16, 17, durch den ein Gas strömt, das dann durch die Löcher 14, 15 tritt. Der Gasstrom ist durch Pfeile 18, 19 angedeutet. Die Zuführung des Gases erfolgte über mehrere Seitenkanäle 20 bis 27, die ihrerseits mit einem mittigen Hauptkanal 28 in Verbindung stehen, der über ein Gaszuführungsrohr 29 gespeist wird. Der Hauptkanal 28 ist hierbei durch eine Ausnehmung 30 in einer Deckenwand 31 gebildet. Die Deckenwand 31 weist auch an denjenigen Stellen Ausnehmungen auf, wo Seitenkanäle 20 bis 27 in die Flutkanäle 16, 17 eintreten.

Das Flutgas gelangt somit über das Gaseinführungsrohr 29 in den Hauptkanal 28 und von dort in die Seitenkanäle 20 bis 27, die in den Flutkanälen 16, 17 enden. Von dort aus gelangt das Flutgas durch die Löcher 14, 15 und trifft auf das Substrat 11 auf. Das Substrat 11 wird gleichzeitig aus den beiden Flutkanälen 16, 17 angeblasen.

Der Gasaustritt aus den Flutwänden 12, 13 muss spiegelbildlich identisch sein, d. h. die einander entsprechenden Löcher der Flutwände 12, 13 stehen sich direkt gegenüber. Ein minimaler Versatz kann aber in Bezug auf Haltewirkung und Resonanz auch Vorteile bringen.

Wichtig ist, dass die Einspeisung des Gases in die Flutkanäle 16, 17 symmetrisch erfolgt und dass stets die gleiche Gasmenge mit der gleichen Geschwindigkeit in die Flutkanäle eintritt. Statt Löchern können auch Düsen, Spalten und dergleichen zum Einsatz kommen.

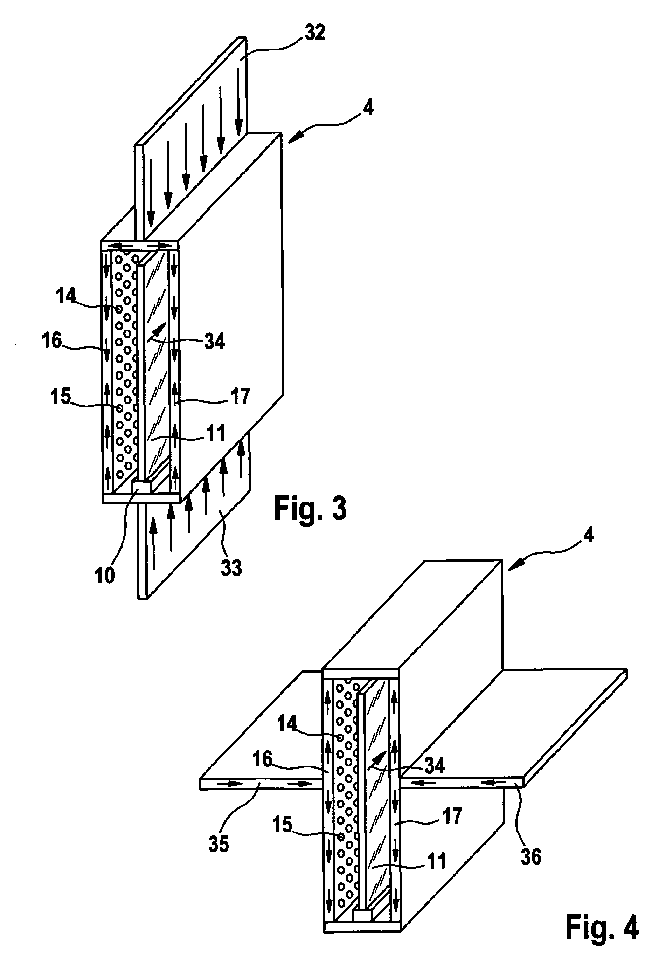

Die Fig. 3 zeigt die gleiche Ausschleuskammer 4 wie die Fig. 2, jedoch schematisch und stark vereinfacht. Man erkennt hierbei, dass die Gaszuführung nicht nur von oben, sondern auch von unten bzw. von oben und unten erfolgen kann. Hierfür sind zwei Gaszuführungen 32, 33 vorgesehen, die in die Flutkanäle 16, 17 einmünden. Der Transport des Substrats 11 erfolgt, wie bei der Ausführungsform der Fig. 2, in Richtung des Pfeils 34. Durch die zweite Gaszuführung 33 wird erreicht, dass die Gasströmung durch die Flutkanäle 16, 17 vergleichmäßigt wird, d. h. es strömt durch die unteren Löcher ebenso viel Gas wie durch die oberen.

In der Fig. 4 ist eine Ausschleuskammer 4 dargestellt, die zwei mittig angeordnete Gaszuführungen 35, 36 aufweist, die senkrecht zu den Flutkanälen 16, 17 verlaufen. Durch diese mittigen Gaszuführungen 35, 36 wird gewährleistet, dass das Gas sich im unteren und oberen Bereich der Flutkanäle 16, 17 gleichmäßig verteilt.

In den Fig. 3 und 4 ist nicht dargestellt, dass die Gaszuführungen 32, 33 oder 35, 36 symmetrisch arbeiten, d. h. die die Gaszuführungen 32, 33 bzw. 35, 36 durchlaufenden Gase kommen aus einer gemeinsamen Quelle. Ohne eine symmetrische Aufteilung des Gasstroms wäre eine aufwändige Regelung notwendig, die sicherstellt, dass den beidseitigen Flutungswänden der gleiche Gasstrom zugeführt wird.

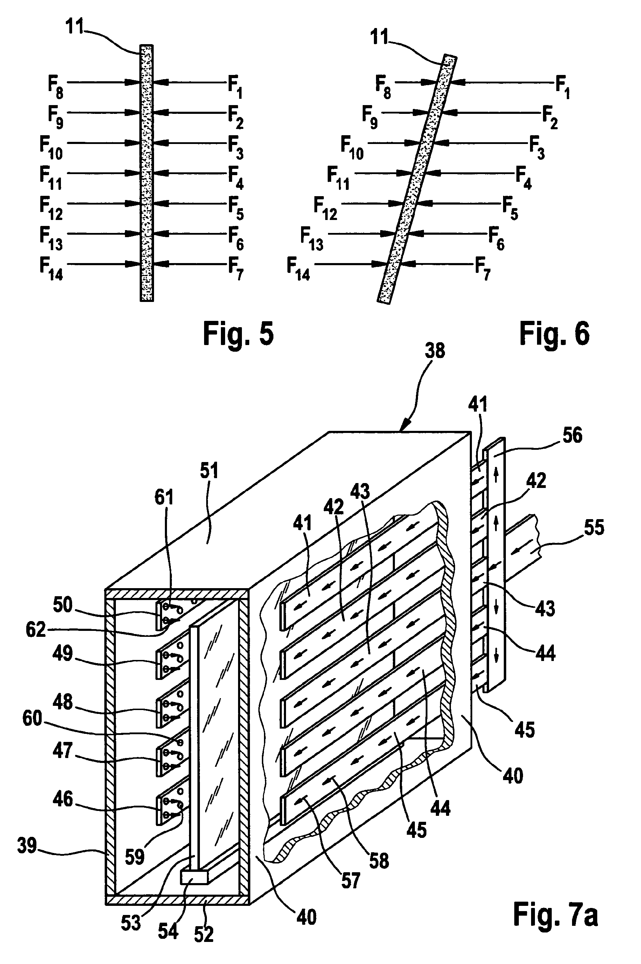

Die Fig. 5 zeigt, dass die auf das Substrat einwirkenden Kräfte sich aufheben. Die Kräfte $F_1$ bis $F_{14}$, die von einem Gasdruck herrühren, der den Löchern 14, 15 entströmt, sind alle gleich groß. Die Kräfte $F_8$ bis $F_{14}$ sind jedoch den Kräften $F_1$ bis $F_7$ entgegengerichtet, sodass sich die Kräfte am Substrat 11 aufheben.

Die Fig. 6 zeigt, wie sich die von der Gasströmung bewirkten Kräfte verhalten, wenn sich das Substrat 11 zur Seite neigt. Weil sich das Substrat 11 in dem Fall den oberen Öffnungen einer Flutwand 12, 13 nähert, bewirkt das dort ausströmende Gas eine größere Kraft, was durch einen langen Kraftpfeil $F_1$ zum Ausdruck kommt. Das Substrat wird hierdurch wieder aufgerichtet, d. h. in die Senkrechte gebracht.

Größenangaben über den dynamischen Druck können nur schwer gemacht werden, weil dieser von vielen Einflussfaktoren abhängt und für den Einzelfall optimiert bzw. empirisch bestimmt werden muss. Ein leichtes Gas, z. B. Wasserstoff, erzeugt einen niedrigeren Druck als ein schweres Gas, z. B. Xenon. Außerdem bestimmen die Anzahl der Löcher und deren Querschnitt den Druck. Auch der Abstand zwischen den Flutungsbalken und dem Substrat stellt eine Einflussgröße dar, desgleichen der Gasdurchsatz.

Darüber hinaus ändert sich der dynamische Druck während der Flutzeit, da bei steigendem statischen Druck in der Kammer einerseits die Aufweitung der Gasstrahlen abnimmt, was die Krafteinwirkung auf das Substrat erhöht, andererseits aber durch zunehmende Verwirbelung die Krafteinwirkung abnimmt.

Welches Gas zum Fluten genommen wird, ist nicht entscheidend. Es werden jedoch kostengünstige Gase bevorzugt. Da bei der erfindungsgemäßen Schnellflutung das Substrat 11 beidseitig mit einem Gasstrom hoher Geschwindigkeit angeblasen wird, ist es unerlässlich, ein sauberes, trockenes und vor allem partikelfreies Gas zu verwenden, damit beim Fluten nicht die Beschichtung beschädigt wird. Ein solches Gas, das die Anforderungen erfüllt, ist z. B. Stickstoff, der in großen Mengen in einem Vorratstank gelagert werden kann. Es kann jedoch auch Luft verwendet werden, wenn diese zuvor getrocknet, gereinigt oder zumindest gefiltert worden ist.

In der Schleusenkammer können sich Partikel befinden, die beispielsweise durch den Beschichtungsprozess entstanden sind und sich auf der Beschichtung ablagern. Wenn der Gasstrom die Beschichtung getroffen hat, werden die Partikel in die Kammer transportiert, sodass das Substrat während des Flutens weitgehend partikelfrei gehalten wird.

Um die notwendigen Gasmengen in möglichst kurzer Zeit in die Schleusenkammer einzubringen, können entweder sehr zahlreiche oder große Löcher 14, 15 vorgesehen werden. Es können aber auch zusätzliche Gaslanzen oder Fluteinrichtungen vorgesehen sein, deren Gasaustrittsrichtung nicht auf das Substrat 11 gerichtet ist. Voraussetzung hierfür ist, dass durch die zusätzlichen Gaszuführungen keine Strömungswirbel entstehen dürfen, die das Substrat aus seiner Position bringen oder fortblasen.

Obgleich auch ein Gasführungsbalken - wie etwa in der DE 103 19 379 A1 beschrieben - ausreichen kann, ist es doch empfehlenswert, die Löcher 14, 15 über die ganze Wand 18 zu verteilen.

In der Fig. 7a ist eine weitere Ausführungsform der Erfindung dargestellt, bei welcher statt Flutungswänden Flutungsbalken vorgesehen sind.

Eine Ausschleuskammer 38, die zwei Seitenwände 39, 40 aufweist, ist mit insgesamt zehn Flutungsbalken 41 bis 45 bzw. 46 bis 50 versehen, von denen sich jeweils fünf Flutungsbalken gegenüberliegen. Nach oben und unten ist die Ausschleuskammer durch eine Deckenwand 51 und einen Boden 52 abgeschlossen. Die Flutungsbalken 41 bis 45 sind in der Fig. 7a sichtbar, weil die Seitenwand 40 durchbrochen dargestellt ist. Zwischen den einander gegenüberliegenden Flutungsbalken befindet sich ein Substrat 53, das mit einer Kante auf einer Transportvorrichtung 54 aufliegt. Die Versorgung der Flutungsbalken 41 bis 50 mit Gas erfolgt über eine Gaszuführung 55, die mit einer Gasverzweigung 56 gekoppelt ist, die ihrerseits an die Flutungsbalken 41 bis 45 anschließt. Die Flutungsbalken 46 bis 50 werden - was in Fig. 7a nicht sichtbar ist - auf die gleiche Weise mit Gas versorgt. Die Strömung des Gases in den Flutungsbalken ist mit Pfeilen 57, 58 angedeutet. Da die Flutungsbalken 41 bis 50 auf ihrer nach innen gerichteten Seite mit Löchern 59, 60 versehen sind, tritt das Gas in Richtung auf das Substrat 53 aus. Dies ist durch Pfeile 61, 62 angedeutet.

Die in der Fig. 7a abgebildete Fluteinrichtung kann auch um 90° gedreht werden, ohne dass sie ihre Funktionsfähigkeit verliert. Die Flutungsbalken 41 bis 50 und die Gaszuführung 55 würden dann senkrecht verlaufen, während die Gasverzweigung 56 waagerecht ver-

laufen würde. Das Substrat 53, die Schleusenöffnung und die Transportvorrichtung 54 behielten dann ihre Richtung.

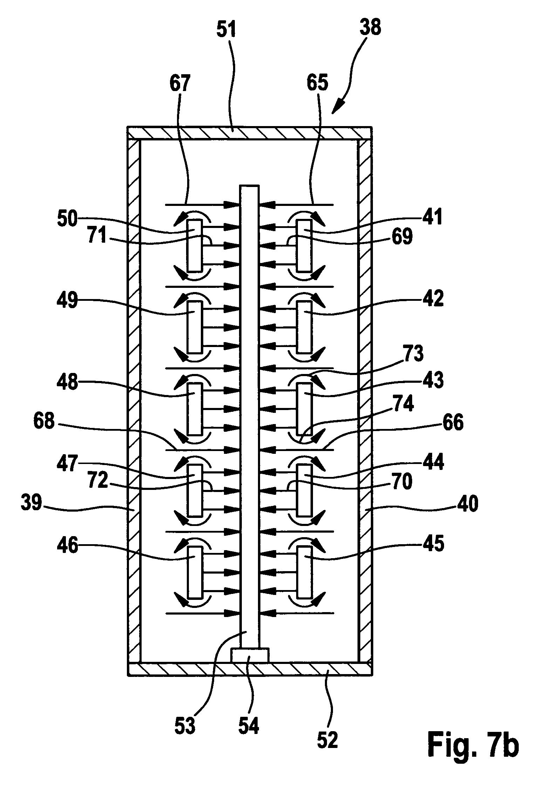

In Fig. 7b ist die Ausschleuskammer 38 in einer Frontansicht dargestellt. Man erkennt hierbei, dass die Flutungsbalken 41 bis 50 in vertikaler Richtung einen Abstand voneinander haben. Dieser Abstand wird gewählt, um einen möglichen negativen Einfluss des statischen Drucks aufzuheben. Unter statischem Druck wird derjenige Druck verstanden, der normalerweise in der Ausschleuskammer 38 herrscht. Im Gegensatz hierzu wird unter dem dynamischen Druck derjenige Druck verstanden, der durch das aus den Flutungsbalken 41 bis 50 in Richtung auf das Substrat 53 austretende Gas erzeugt wird.

Der statische Druck ist in der Fig. 7b durch die Pfeile 65 bis 68 gekennzeichnet, während der dynamische Druck durch die Pfeile 69 bis 72 dargestellt ist. Mit den Pfeilen 73, 74 ist angedeutet, dass die auf das Substrat 53 auftreffenden Gasstrahlen 69, 70 wieder in Richtung auf die Wand 40 abgeleitet werden.

Durch beide Drücke wirken Kräfte auf das Substrat 53 ein. Durch die Verwendung von Flutungsbalken 41 bis 50 statt durchgehenden Flutungswänden wird verhindert, dass sich auf den Seiten rechts und links vom Substrat unterschiedliche Drücke aufbauen. Teilt das Substrat 53 bei Verwendung von durchgehenden Wänden die Ausschleuskammer 38 in zwei Abteilungen auf, so wird die Überströmung zwischen den beiden Abteilungen durch hohe Strömungswiderstände behindert, und es bilden sich auf beiden Seiten unterschiedliche statische Drücke aus. Die hieraus resultierenden statischen Druckunterschiede können das Substrat 53 zerstören oder aus der Mittellage bewegen. Durch die Verwendung der Flutungsbalken wird dies verhindert, weil einerseits der hohe dynamische Druck, der von ihm ausgeht, den relativ niedrigen statischen Druck überlagert, und weil andererseits aufgrund der vertikalen Abstände zwischen den Flutungsbalken ein zusätzlicher Druckausgleich zwischen beiden Seiten des Substrats geschaffen wird.

Der statische Druck ist keine feste Größe, da Schleusenkammern vom Druckniveau einer Prozesskammer - ca. $1 \cdot 10^{-3}$ hPa - bis hin zum Atmosphärendruck aufgefüllt werden. Ob die Flutungsbalken 41 bis 50 horizontal oder vertikal angeordnet sind, ist unerheblich. Wichtig ist jedoch, dass das über die Flutungsbalken 41 bis 50 einströmende Gas symmetrisch zum Substrat 53 eingeleitet wird, eine stabilisierende und dämpfende Wirkung auf das Substrat 53 hat und das restliche Kammervolumen so geflutet wird, dass der sich aufbauende statische Druck das Substrat 53 nicht beschädigen kann.

Um eine gezielte Haltewirkung durch den dynamischen Druck zu erreichen, sollte die Summe der Querschnittsflächen der Löcher in den Flutungsbalken kleiner oder gleich dem zugeordneten Zuleitungsquerschnitt der jeweiligen Fluteinrichtung sein.

Eine Drehung um 90 Grad, wie im Zusammenhang mit Fig. 7a beschrieben, ist auch bei der Anordnung gemäß Fig. 7b möglich. In diesem Fall wäre die Fig. 7b eine Draufsicht.

## Patentansprüche

1. Flutungskammer für Beschichtungsanlagen, enthaltend wenigstens zwei Flutungseinrichtungen (12, 13; 41 - 45, 46 - 50), zwischen denen ein Substrat (11, 53) symmetrisch angeordnet ist, wobei die Flutungseinrichtungen (12, 13; 41 - 45, 46 - 50) einen Gasstrahl (69, 70) direkt auf das Substrat (11, 53) richten, so dass das Substrat (11, 53) zwischen den Flutungseinrichtungen (12, 13; 41 - 45, 46 - 50) fixiert wird und die Flutungseinrichtungen (12, 13; 41 - 45, 46 - 50) an wenigstens eine Fluidquelle (29, 55) mit vorgegebenem Fluiddruck angeschlossen sind.

2. Flutungskammer nach Anspruch 1, **dadurch gekennzeichnet, dass** die Flutungseinheiten Flutungswände (12, 13) sind, die mehrere Fluid-Durchtrittsöffnungen (14, 15) aufweisen.

3. Flutungskammer nach Anspruch 2, **dadurch gekennzeichnet, dass** zumindest ein Teil der Fluid-Durchtrittsöffnungen (14, 15) auf ein Substrat (11) hin gerichtet ist.

4. Flutungskammer nach Anspruch 1, **dadurch gekennzeichnet, dass** die Flutungseinheiten Flutungsbalken (41 - 45, 46 - 50) sind, die mehrere Fluid-DurchtrKsöffnungen (59, 60) aufweisen.

5. Flutungskammer nach Anspruch 4, **dadurch gekennzeichnet, dass** die Flutungsbalken (41 - 45, 46 - 50) in horizontaler Richtung einen Abstand voneinander haben.

6. Flutungskammer nach Anspruch 1, **dadurch gekennzeichnet, dass** das Fluid Luft ist.

7. Flutungskammer nach Anspruch 1, **dadurch gekennzeichnet, dass** das Fluid Stickstoff ist.

8. Flutungskammer nach Anspruch 2, **dadurch gekennzeichnet, dass** die Flutungswände (12, 13) zusammen mit Vakuumkammerwänden (6, 7) Hohlräume (16, 17) bilden.

9. Flutungskammer nach Anspruch 2, **dadurch gekennzeichnet, dass** die Fluid-Durchtrittsöffnungen (14, 15) über die ganze Seite einer Flutungswand (12, 13) verteilt sind und jeweils den gleichen Abstand zueinander haben.

10. Flutungskammer nach Anspruch 8, **dadurch gekennzeichnet, dass** die Hohlräume (16, 17) an einer gemeinsamen Fluidquelle (29) liegen.

**11.** Flutungskammer nach Anspruch 8, **dadurch gekennzeichnet, dass** die Hohlräume (16, 17) an zwei gemeinsamen Fluidquellen (32, 33; 35, 36) liegen.

**12.** Flutungskammer nach Anspruch 1, **dadurch gekennzeichnet, dass** die Fluidquellen (32, 33) mit den Schmalseiten der Hohlräume (16, 17) verbunden sind.

**13.** Flutungskammer nach Anspruch 1, **dadurch gekennzeichnet, dass** die Fluidquelle (35, 36) mit den Mittellinien der Hohlräume (16, 17) verbunden ist.

**14.** Flutungskammer nach Anspruch 4, **dadurch gekennzeichnet, dass** die Flutungsbalken (41 - 45, 46 - 50) in vertikaler Richtung einen Abstand voneinander haben.

**Claims**

**1.** Flooding chamber for coating installations, comprising at least two flooding units (12, 13; 41 - 45, 46 - 50), between which a substrate (11, 53) is disposed symmetrically, wherein the flooding units (12, 13; 41 - 45, 46 - 50) direct a gas jet (69, 70) directly onto the substrate (11, 53) so that the substrate (11, 53) is fixed between the flooding units (12, 13; 41 - 45, 46 - 50) and wherein the flooding units (12, 13; 41 - 45, 46 - 50) are connected to at least one fluid source (29, 55) at a given fluid pressure.

**2.** Flooding chamber as claimed in claim 1, **characterized in that** the flooding units are flooding walls (12, 13) which comprise several fluid penetration openings (14, 15).

**3.** Flooding chamber as claimed in claim 2, **characterized in that** at least a portion of the fluid penetration openings (14, 15) is directed toward a substrate (11).

**4.** Flooding chamber as claimed in claim 1, **characterized in that** the flooding units are flooding bars (41 - 45, 46 - 50) which comprise several fluid penetration openings (59, 60).

**5.** Flooding chamber as claimed in claim 4, **characterized in that** the flooding bars (41 - 45, 46 - 50) are spaced apart from one another in the horizontal direction.

**6.** Flooding chamber as claimed in claim 1, **characterized in that** the fluid is air.

**7.** Flooding chamber as claimed in claim 1, **characterized in that** the fluid is nitrogen.

**8.** Flooding chamber as claimed in claim 2, **characterized in that** the flooding walls (12, 13) form together with vacuum chamber walls (6, 7) hollow spaces (16, 17).

**9.** Flooding chamber as claimed in claim 2, **characterized in that** the fluid penetration openings (14, 15) are distributed over the entire side of a flooding wall (12, 13) and are each disposed at the same distance from one another.

**10.** Flooding chamber as claimed in claim 8, **characterized in that** the hollow spaces (16, 17) are connected to a common fluid source (29).

**11.** Flooding chamber as claimed in claim 8, **characterized in that** the hollow spaces (16, 17) are connected to two common fluid sources (32, 33; 35, 36).

**12.** Flooding chamber as claimed in claim 1, **characterized in that** the fluid sources (32, 33) are connected with the narrow sides of the hollow spaces (16, 17).

**13.** Flooding chamber as claimed in claim 1, **characterized in that** the fluid source (35, 36) is connected with the center lines of the hollow spaces (16, 17).

**14.** Flooding chamber as claimed in claim 4, **characterized in that** the flooding bars (41 - 45, 46 - 50) in the vertical direction have a distance from one another.

**Revendications**

**1.** Chambre de refoulement pour installations de revêtement, comprenant au moins deux dispositifs de refoulement (12, 13; 41 - 45, 46 - 50) entre lesquels un substrat (11, 53) est disposé de manière symétrique, les dispositifs de refoulement (12, 13; 41 - 45, 46 - 50) dirigeant un jet de gaz (69, 70) directement sur le substrat (11, 53) de sorte que ledit substrat (11, 53) est fixé entre les dispositifs de refoulement (12, 13; 41 - 45, 46 - 50), et en ce que les dispositifs de refoulement (12, 13; 41 - 45, 46 - 50) sont raccordés à au moins une source de fluide (29, 55).

**2.** Chambre de refoulement selon la revendication 1, **caractérisée en ce que** les unités de refoulement sont des parois de refoulement (12, 13) qui présentent plusieurs orifices de passage de fluide (14, 15).

**3.** Chambre de refoulement selon la revendication 2, **caractérisée en ce qu'**au moins une partie des orifices de passage de fluide (14, 15) est dirigée vers un substrat (11).

**4.** Chambre de refoulement selon la revendication 1, **caractérisée en ce que** les unités de refoulement sont des barres de refoulement (41 - 45, 46 - 50) qui présentent plusieurs orifices de passage de fluide (59, 60).

5. Chambre de refoulement selon la revendication 4, **caractérisée en ce que** les barres de refoulement (41 - 45, 46 - 50) présentent, en sens horizontal, un écart donné entre elles.

6. Chambre de refoulement selon la revendication 1, **caractérisée en ce que** le fluide est de l'air.

7. Chambre de refoulement selon la revendication 1, **caractérisée en ce que** le fluide est de l'azote.

8. Chambré de refoulement selon la revendication 2, **caractérisée en ce que** les parois de refoulement (12, 13) forment ensemble avec des parois de chambre à vide (6, 7) des espaces vides (16, 17).

9. Chambre de refoulement selon la revendication 2, **caractérisée en ce que** les orifices de passage de fluide (14, 15) sont répartis sur toute la face d'une paroi de refoulement (12, 13) et présentent respectivement le même écart entre eux.

10. Chambre de refoulement selon la revendication 8, **caractérisée en ce que** les espaces vides (16, 17) sont reliés à une source de fluide (29) commune.

11. Chambre de refoulement selon la revendication 8, **caractérisée en ce que** les espaces vides (16, 17) sont reliés à deux sources de fluide (32, 33; 35, 36) communes.

12. Chambre de refoulement selon la revendication 1, **caractérisée en ce que** les sources de fluide (32, 33) sont reliées aux côtés étroits des espaces vides (16, 17).

13. Chambre de refoulement selon la revendication 1, **caractérisée en ce que** la source de fluide (35, 36) est reliée aux lignes médianes des espaces vides (16, 17).

14. Chambre de refoulement selon la revendication 4, **caractérisée en ce que** les barres de refoulement (41 - 45, 46 - 50) présentent, en sens vertical, un écart donné entre elles.

Fig. 1

Fig. 2

8

**Fig. 3**

**Fig. 4**

**Fig. 5**

**Fig. 6**

**Fig. 7a**

**Fig. 7b**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004008598 A1
- WO 2004096678 A1
- DE 10119766 A1
- US 20050103271 A1
- DE 10319379 A1